# EUROPÄISCHE PATENTANMELDUNG

(11) **EP 1 075 171 A1**
(43) Veröffentlichungstag der Anmeldung: **07.02.2001**
(21) Anmeldenummer: 00114722.2
(22) Anmeldetag: 08.07.2000
(51) Int. Cl.: H05K 3/46

(54) **Leiterplatte**

(30) Priorität: 31.07.1999 DE 19936198
(71) Anmelder: Mannesmann VDO Aktiengesellschaft, 60388 Frankfurt am Main (DE)
(72) Erfinder: Kronenberg, Hartmut, Nordseebad Burhave, 26969 Butjadingen (DE)
(74) Vertreter: Rassler, Andrea, Dipl.-Phys.

(57) **Zusammenfassung**

Eine Leiterplatte (1) mit durch eine beidseitige Kaschierung (2, 3) auf beiden Seiten gebildeten Leiterbahnen und Leiterbahnen miteinander verbindenden Durchkontaktierungen (13) hat auf den beiden Kaschierungen (2, 3) einzelne Leiterbahnen miteinander verbindende und andere Leiterbahnen derselben Seite überbrückende Querverbindungen (9, 10). Dadurch entsteht auf sehr kostengünstige Weise eine Leiterplatte (1) mit mehreren Lagen auf jeder Seite.

## Beschreibung

Die Erfindung betrifft eine Leiterplatte mit durch eine beidseitige Kaschierung auf beiden Seiten gebildeten Leiterbahnen und Leiterbahnen miteinander verbindenden Durchkontaktierungen.

Solche Leiterplatten werden derzeit beispielsweise in elektronischen Instrumenten eingesetzt und sind allgemein bekannt. Die Anordnung von Leiterbahnen auf beiden Seiten der Leiterplatte erlaubt eine Entflechtung mit Kreuzungen und die Bestückung mit elektronischen Bauteilen auf beiden Seiten.

Außer durchkontaktierten Leiterplatten sind in jüngster Zeit auch Leiterplatten bekanntgeworden, bei denen ausschließlich auf einer Seite Leiterbahnen vorgesehen sind, über welche jedoch elektrisch isolierte Querverbindungen hinwegführen, um eine zweite Leiterbahnlage zu erzeugen. Diese Art der Erzeugung von Querverbindungen ist als Cross-Over-Technik bekanntgeworden.

Der Erfindung liegt das Problem zugrunde, eine Leiterplatte der eingangs genannten Art zu entwickeln, welche mit möglichst geringem Kostenaufwand die Anordnung von Leiterbahnen in zumindest vier Ebenen erlaubt.

Dieses Problem wird erfindungsgemäß dadurch gelöst, dass auf den beiden Kaschierungen einzelne Leiterbahnen miteinander verbindende und andere Leiterbahnen derselben Seite überbrückende Querverbindungen aufgebracht sind.

Bei einer solchen Leiterplatte wird die Cross-Over-Technik erstmals bei durchkontaktierten Leiterplatten angewandt. Dadurch wird aus einer Leiterplatte mit beidseitiger Kaschierung mit relativ geringem zusätzlichen Aufwand eine Leiterplatte mit vier Lagen von Leiterbahnen. Diese Zahl der Lagen kann man weiter erhöhen, wenn man jeweils abwechselnd auf den Querverbindungen wieder eine Lage mit Leiterbahnen und darauf erneut Querverbindungen erzeugt.

Besonders kostengünstig ist die Leiterplatte herstellbar, wenn die Querverbindungen auf jeder Seite der Leiterplatte durch eine aufgedruckte Isolierschicht und darauf aufgebrachte Leiterbahnen gebildet sind.

Zum Schutz der Querverbindungen vor Migrationen ist es vorteilhaft, wenn die Querverbindungen der Leiterplatte durch einen elektrisch isolierenden Abdeckdruck abgedeckt sind, welcher die Breite der jeweiligen Querverbindung um zumindest 0,5 mm überragt.

Zur Vermeidung eines Stromflusses von den Querverbindungen zu den überbrückten Leiterbahnen ist es sinnvoll, wenn die Isolationsschicht unter den Querverbindungen bei der fertigen Leiterplatte bei jeder Querverbindung zumindest 0,5 mm über die Breite der jeweiligen Querverbindung ragt.

Die Erfindung lässt verschiedene Ausführungsformen zu. Zur weiteren Verdeutlichung ihres Grundprinzips ist eine davon in der Zeichnung schematisch dargestellt und wird nachfolgend beschrieben. Die Zeichnung zeigt in
- Fig.1: einen Schnitt durch eine erfindungsgemäße Leiterplatte,
- Fig.2: eine Draufsicht auf eine Seite der Leiterplatte,
- Fig.3: den Aufbau einer Seite der Leiterplatte in Explosionsdarstellung.

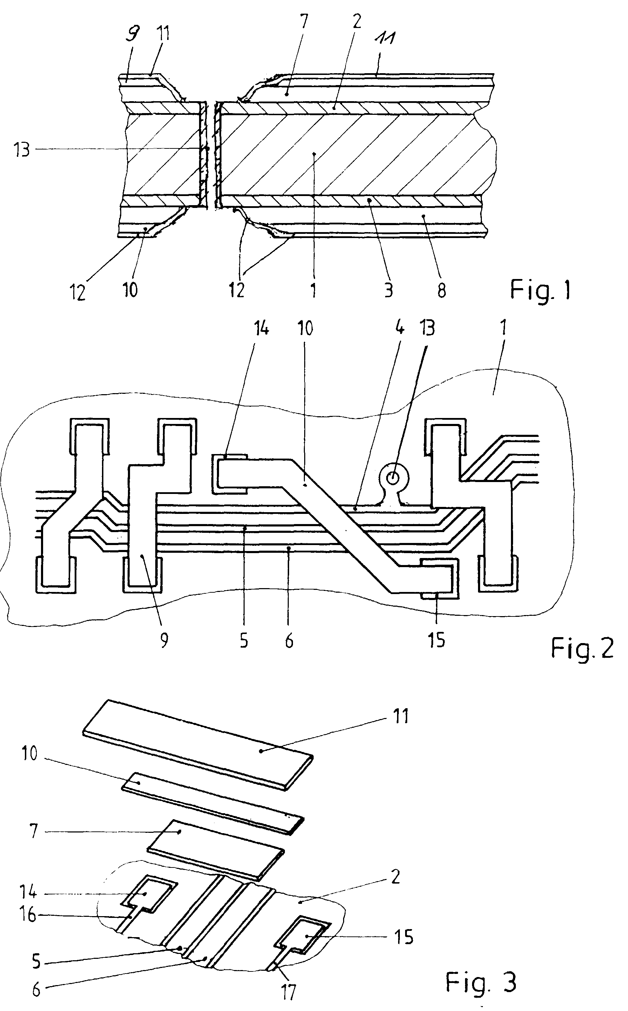

Die Figur 1 zeigt im Schnitt einen Teilbereich einer Leiterplatte 1, welche auf ihren beiden Seiten jeweils eine Kaschierung 2, 3 aus Kupfer aufweist. Diese Kaschierungen 2, 3 bilden in Figur 2 gezeigte Leiterbahnen 4, 5, 6, 16, 17. Auf den Kaschierungen 2, 3 ist jeweils eine Isolationsschicht 7, 8 aufgebracht, auf der Querverbindungen 9, 10 verlaufen, welche außenseitig durch einen Abdeckdruck 11, 12 abgedeckt sind. Eine Durchkontaktierung 13 verbindet Leiterbahnen der beiden Kaschierungen 2, 3.

Die Figur 2 verdeutlicht, wie die Querverbindungen 9, 10 über die Leiterbahnen 4, 5, 6 führen. Diese Querverbindungen 9, 10 beginnen jeweils auf einem sogenannten Kupferpad 14, 15. Die Querverbindungen 9, 10 werden jeweils durch eine leitende Paste erzeugt, die eingebrannt wird.

Die Figur 3 zeigt die Kaschierung 2 mit zwei Leiterbahnen 5, 6 und beidseitig dazu jeweils den Kupferpad 14, 15, der jeweils als Endbereich jeweils einer Leiterbahn 16, 17 ausgebildet ist. Oberhalb der Leiterbahnen 5, 6 sind die Isolationsschicht 7, die Querverbindung 10 für die Verbindung der Kupferpads 14, 15 und der Abdeckdruck 11 dargestellt.

## Patentansprüche

1. Leiterplatte mit durch eine beidseitige Kaschierung auf beiden Seiten gebildeten Leiterbahnen und Leiterbahnen miteinander verbindenden Durchkontaktierungen, **dadurch gekennzeichnet,** dass auf den beiden Kaschierungen (2, 3) einzelne Leiterbahnen (16, 17) miteinander verbindende und andere Leiterbahnen (4, 5, 6) derselben Seite überbrückende Querverbindungen (9, 10) aufgebracht sind.

2. Leiterplatte nach Anspruch 1, **dadurch gekennzeichnet,** dass die Querverbindungen (9, 10) auf jeder Seite der Leiterplatte (1) durch eine aufgedruckte Isolierschicht (7) und darauf aufgebrachte Leiterbahnen gebildet sind.

3. Leiterplatte nach Anspruch 2, **dadurch gekennzeichnet,** dass die Querverbindungen (9, 10) auf der äußeren Seite der Leiterplatte (1) durch einen elektrisch isolierenden Abdeckdruck (11, 12) abgedeckt sind, welcher die Breite der jeweiligen Querverbindung (9, 10) um zumindest 0,5 mm überragt.

4. Leiterplatte nach zumindest einem der vorangehenden Ansprüche, **dadurch gekennzeichnet,** dass die Isolationsschicht (7, 8) bei der fertigen Leiterplatte (1) bei jeder Querverbindung (9, 10) zumindest 0,5 mm über die Breite der jeweiligen Querverbindung (9, 10) ragt.
